# EUROPÄISCHE PATENTANMELDUNG

(11) **EP 1 424 243 A2**
(43) Veröffentlichungstag der Anmeldung: **02.06.2004**
(21) Anmeldenummer: 03026459.2
(22) Anmeldetag: 20.11.2003
(51) Int. Cl.: B60R 16/02, H02J 7/14

(54) **Steuerungseinrichtung eines Kraftfahrzeuges mit einer batteriebetriebenen Fernbedienung und eine Einrichtung zum überwachen des Batterie-Ladezustands**

(30) Priorität: 29.11.2002 DE 10255804
(71) Anmelder: ADAM OPEL AG, 65423 Rüsselsheim (DE)
(72) Erfinder: Bald, Heiko, 64397 Modautal (DE)

(57) **Zusammenfassung**

Eine Steuerungseinrichtung eines Kraftfahrzeuges umfasst eine batteriebetriebene Fernbedienung (2), die tastengesteuert Signale an einen Empfänger (8) eines kraftfahrzeugseitigen Steuergerätes (7) überträgt, und eine Überwachungseinrichtung (11) für den Ladezustand der Batterie (3) sowie eine Ladezustandsanzeige (13). Die Überwachungseinrichtung (11) ist in dem Steuergerät (7) integriert.

## Beschreibung

Die Erfindung bezieht sich auf eine Steuerungseinrichtung eines Kraftfahrzeuges mit einer batteriebetriebenen Fernbedienung, die tastengesteuert Signale an ein kraftfahrzeugseitiges Steuergerät überträgt, und mit einer Überwachungseinrichtung für den Ladezustand der Batterie sowie einer Ladezustandsanzeige.

Die DE 41 05 369 C1 zeigt eine Ladezustandsanzeige einer Batterie oder eines Akkumulators in einem Fernbedienungsgeber für nachrichtentechnische Geräte, der mittels Tasten, Analogwert-stellern oder Sprache eingegebene Befehle in einer Befehlsaufbereitungsschaltung aufbereitet und in einer Sendeschaltung mit einem Träger moduliert oder unmoduliert an das zu steuernde Gerät mit einem Übertragungsmedium, wie Infrarotlicht, Ultraschall oder elektromagnetischen Wellen, überträgt, mit einer Überwachungseinrichtung für die Überwachung des Ladezustandes und/oder der entsprechenden Spannung der Batterie oder des Akkumulators. Das Gerät weist eine Empfängerschaltung auf, die die Befehle demoduliert, aufbereitet oder direkt zur Funktionssteuerung an die zu steuernden Funktionselemente in dem Gerät leitet. Die Überwachungseinrichtung generiert in Abhängigkeit von dem Ladezustand der Batterie oder des Akkumulators ein adäquates Informationssignal, das von dem Fernbedienungsgeber an das zu steuernde Gerät übertragen wird, das einen Fernbedienungsempfänger und eine Auswerteschaltung für das Informationssignal und ein Anzeigeelement mit einer Ansteuerschaltung zur Anzeige des Ladezustandes enthält. Da die Überwachungseinrichtung für die Überwachung des Ladezustandes der Batterie bzw. des Akkumulators in dem Fernbedienungsgeber integriert ist, weist dieser einen komplexen Aufbau auf.

Des Weiteren offenbart die DE 40 38 038 C1 ein Fernbedienungssystem, das einen Sender mit einem Stromspeicher und einer durch einen Benutzer zu betätigenden Sendetaste zum willkürlichen Abstrahlen von aus dem Stromspeicher gespeisten Steuersignalen, eine Ladekontrolleinrichtung für den Ladezustand des Stromspeichers des Senders mit einer Ladezustandsanzeige zur Erzeugung eines an den Benutzer gerichteten Signals und eine Aufnahme zum Einstecken und Kontaktieren des Senders mit einem der Aufnahme nachgeschalteten Aggregat umfasst. Die Ladekontrolleinrichtung und die Ladezustandsanzeige sind außerhalb des Senders angeordnet, wobei die Ladekontrolleinrichtung der Aufnahme nachgeschaltet ist. Die Kontrolle des Ladezustands des Stromspeichers erfolgt bei in die Aufnahme eingestecktem und innerhalb dieser betätigtem Sender durch die Ladekontrolleinrichtung, wobei die Ladezustandsanzeige bei unterhalb eines Mindestwerts liegendem Ladestand des Stromspeichers mittels einer externen Quelle aktiviert wird. Zur Kontrolle des Ladezustands des Stromspeichers ist somit ein separates Teil, nämlich eine Aufnahme, erforderlich und der Benutzer des Fernbedienungssystems muss den Sender in die Aufnahme einsetzen, um eine Information bezüglich des Ladezustands zu erhalten. Im Weiteren ist der Ladezustandsanzeige eine externe Stromquelle zugeordnet.

Darüber hinaus ist aus der DE 197 52 278 A1 eine Steuerung für ein Kraftfahrzeug mit Fernbedienung oder Transponder zur Übertragung von Informationen an einen im Kraftfahrzeug untergebrachten Empfänger bekannt, bei der die Fernbedienung oder der Transponder eine Batterie oder einen Akkumulator aufweist. Die Fernbedienung oder der Transponder umfasst eine Überwachungseinheit für den Ladezustand der Batterie oder des Akkumulators und eine Ladezustandskennung ist mit einem gesonderten Steuerbefehl übertragbar. Die Ladezustandskennung wird im Kraftfahrzeug zur Anzeige gebracht und kennzeichnet dort den Ladezustand der Batterie oder des Akkumulators der Fernbedienung oder des Transponders.

Es ist Aufgabe der Erfindung, eine Steuerungseinrichtung der eingangs genannten Art zu schaffen, die bei einem einfachen Aufbau einen Benutzer der Fernbedienung über den Ladezustand der Batterie in der Fernbedienung informiert.

Erfindungsgemäß wird die Aufgabe dadurch gelöst, dass die Überwachungseinrichtung in dem Steuergerät integriert ist.

Aufgrund dieser Maßnahme ist die Überwachung des Ladezustandes der Batterie der Fernbedienung mit einfachen Mitteln zu realisieren. Die Überwachungseinrichtung kann auf elektronische Komponenten des Steuergerätes und dessen Empfänger zurückgreifen, so dass es beispielsweise nicht erforderlich ist, für die Überwachungseinrichtung separate Mikroprozessoren bzw. Speichermodule oder dergleichen vorzusehen. Darüber hinaus ist das Steuergerät in das Fahrzeugnetzwerk eingebunden und kann Informationen bezüglich des Ladezustandes an weitere dem Netzwerk zugeordnete elektronische Geräte liefern.

Nach einer vorteilhaften Ausgestaltung der Erfindung addiert die Überwachungseinrichtung die Anzahl der von der Fernbedienung an das Steuergerät gesendeten Signale, multipliziert die Anzahl der Signale mit einem empirischen Einzelentladungswert zu einem Entladungswert, speichert diesen Entladungswert in einem Speichermodul des Steuergerätes und subtrahiert den Entladungswert von einem Voll-Ladezustand der Batterie. Zweckmäßigerweise ordnet die Überwachungseinrichtung dem Entladungswert eine betriebszeitabhängige Entladung zu. Von der Überwachungseinrichtung unter ausschließlicher Nutzung der Komponenten des Steuergerätes durchgeführte Schritte führen zu einer relativ zuverlässigen Ermittlung der Restkapazität, also des Ladezustandes, der Batterie, wobei gleiches selbstverständlich auch für die Restkapazität eines Akkumulators gilt.

Bevorzugt ist die Überwachungseinrichtung mit einer Rücksetzeinrichtung für den Entladungswert gekoppelt, deren Beaufschlagung bei einem Wechsel der Batterie den Kapazitätswert des Voll-Ladezustandes in das Speichermodul einschreibt. Durch die Rücksetzeinrichtung ist es nicht erforderlich, eine permanente bidirektionale Datenübertragung zwischen der Fernbedienung und dem Steuergerät zur Erkennung des Ladezustandes der Batterie nach einem Wechsel derselben bereitzustellen.

Zweckmäßigerweise ist die Rücksetzeinrichtung zum Einschreiben des Kapazitätswertes des Voll-Ladezustandes über einen Diagnosestecker eines Fahrzeug-Bussystems mit einem Diagnosetestgerät verbunden. Mittels des Diagnosetestgerätes lässt sich von einer in der Regel den Batteriewechsel durchführenden Fachwerkstatt der exakte Kapazitätswert der neuen Batterie in das Speichermodul des Steuergerätes einschreiben.

Vorzugsweise umfasst die Rücksetzeinrichtung einen manuell beaufschlagbaren Rücksetzschalter. Dieser Rücksetzschalter kann entweder dem Diagnosetestgerät oder dem Kraftfahrzeug zugeordnet sein. Bei einem kraftfahrzeugseitigen Rücksetzschalter ist es auch dem Benutzer der Fernbedienung möglich, nach einem Batteriewechsel den Kapazitätswert des Voll-Ladezustandes der neuen Batterie in das Speichermodul einzuschreiben. Hierbei wird auf einen üblichen Kapazitätswert der in der Fernbedienung zu benutzenden Batterie zurückgegriffen. Dieser Kapazitätswert kann ebenfalls in dem Speichermodul des Steuergerätes hinterlegt sein.

Zur Vermeidung zusätzlicher Datenleitungen ist die Überwachungseinrichtung vorteilhafterweise über das Fahrzeug-Bussystem mit der Ladezustandsanzeige gekoppelt. Die Ladezustandsanzeige kann beispielsweise als einfache Leuchtdiode innerhalb eines Instruments in einer Armaturentafel des Kraftfahrzeuges ausgebildet sein.

Um einen zusätzlichen Montage- und Geräteaufwand für die Ladezustandsanzeige zu vermeiden, ist bevorzugt die Ladezustandsanzeige in eine Anzeigeeinrichtung eines Bordcomputers im Innenraum des Kraftfahrzeuges integriert.

Für die Anzeige einer visuell leicht wahrnehmbaren Information für den Benutzer bezüglich des Ladezustandes der Batterie bringt zweckmäßigerweise die Anzeigeeinrichtung die Restkapazität der Batterie symbolisch oder als Klartext zur Darstellung. Um den Benutzer darüber hinaus auf einen kritischen Ladezustand der Batterie aufmerksam zu machen, stellt die Ladezustandsanzeige bei Unterschreiten eines vorgegebenen Restkapazitäts-Schwellwertes rechnergesteuert ein Warnsignal dar.

Bevorzugt ist die Fernbedienung als Funkschlüssel und das Steuergerät als Zentralverriegelungssteuergerät ausgebildet.

Es versteht sich, dass die vorstehend genannten und nachstehend noch zu erläuternden Merkmale nicht nur in der jeweils angegebenen Kombination, sondern auch in anderen Kombinationen verwendbar sind. Der Rahmen der vorliegenden Erfindung ist nur durch die Ansprüche definiert.

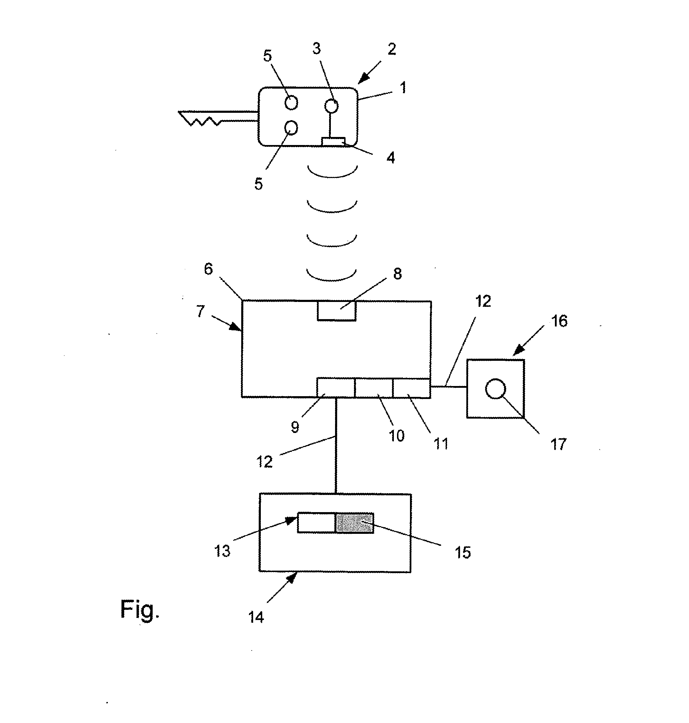

Die Erfindung wird im Folgenden anhand eines Ausführungsbeispieles unter Bezugnahme auf die zugehörige Zeichnung näher erläutert. Die einzige Figur zeigt eine Darstellung eines Blockschaltbildes einer erfindungsgemäßen Steuerungseinrichtung.

Die Steuerungseinrichtung umfasst eine als Fünkschlüssel 1 ausgebildete Fernbedienung 2 mit einem von einer Batterie 3 gespeisten Sender 4, der bei Beaufschlagung einer der Tasten 5 des Funkschlüssels 1 Signale zum Ent- bzw. Verriegeln eines Kraftfahrzeuges an ein als Zentralverriegelungssteuergerät 6 ausgebildetes Steuergerät sendet. Das Zentralverriegelungssteuergerät 6 umfasst hierzu einen Empfänger 8, der mit einem Rechner 9 gekoppelt ist, wobei der Rechner 9 wiederum mit einem Speichermodul 10 in Verbindung steht.

Zur Überwachung des Ladezustandes der Batterie 3 des Funkschlüssels 1 ist eine Überwachungseinrichtung 11 in das Zentralverriegelungssteuergerät 6 integriert, die im Wesentlichen von dem Rechner 9 und dem Speichermodul 10 des Zentralverriegelungssteuergerätes 6 Gebrauch macht. Die Überwachungseinrichtung 11 addiert die Anzahl der von dem Funkschlüssel 1 tastengesteuert an das Zentralverriegelungssteuergerät 6 gesendeten Signale und multipliziert die Anzahl der Signale mit einem empirisch ermittelten Einzelentladungswert zu einem Entladungswert. Dem Entladungswert ordnet die Überwachungseinrichtung 11 eine betriebszeitabhängige Entladung zu, deren Wert statistisch oder ebenfalls empirisch ermittelt wird. Den Entladungswert speichert die Überwachungseinrichtung 11 in dem Speichermodul 10 des Zentralverriegelungssteuergerätes 6 und subtrahiert ihn von einem Voll-Ladezustand der Batterie, der der 100%-igen Kapazität entspricht. Sonach liegt die Restkapazität der Batterie, also deren aktueller Ist-Ladezustand, im Zentralverriegelungssteuergerät 6 vor. Zur Darstellung des Ladezustands der Batterie 3 des Funkschlüssels 1 ist die in das Zentralverriegelungssteuergerät 6 integrierte Überwachungseinrichtung 11 über ein Fahrzeug-Bussystem 12 mit einer Ladezustandsanzeige 13 gekoppelt, wobei die Ladezustandsanzeige 13 in einer Anzeigeeinrichtung 14 eines Bordcomputers im Innenraum des Kraftfahrzeuges untergebracht ist. Die Anzeigeeinrichtung bringt die Restkapazität der Batterie 3 symbolisch als abnehmender Balken 15 zur Darstellung.

Um nach einem Wechsel der Batterie 3 des Funkschlüssels 1 der Überwachungseinrichtung 11 eine diesbezügliche Information zu liefern, ist die Überwachungseinrichtung 11 über das Fahrzeug-Bussystem 12 mit einer Rücksetzeinrichtung 16 gekoppelt. Die Rücksetzeinrichtung 16 ist als manuell beaufschlagbarer kraftfahrzeugseitiger Rücksetzschalter 17 ausgebildet. Die Beaufschlagung des Rücksetzschalters 17 nach einem Wechsel der Batterie 3 des Funkschlüssels 1 bewirkt eine Überschreibung des in dem Speichermodul 10 hinterlegten Entladungswertes mit einem Kapazitätswert, der dem Voll-Ladezustand einer neuen Batterie entspricht.

### Bezugszeichenliste

- 1.: Funkschlüssel
- 2.: Fernbedienung
- 3.: Batterie
- 4.: Sender
- 5.: Taste
- 6.: Zentralverriegelungs-steuergerät
- 7.: Steuergerät
- 8.: Empfänger
- 9.: Rechner
- 10.: Speichermodul
- 11.: Überwachungseinrichtung
- 12.: Fahrzeug-Bussystem
- 13.: Ladezustandsanzeige
- 14.: Anzeigeeinrichtung
- 15.: Balken
- 16.: Rücksetzeinrichtung
- 17.: Rücksetzschalter

## Patentansprüche

1. Steuerungseinrichtung eines Kraftfahrzeuges mit einer batteriebetriebenen Fernbedienung (2), die tastengesteuert Signale an einen Empfänger (8) eines kraftfahrzeugseitigen Steuergerätes (7) überträgt, und mit einer Überwachungseinrichtung (11) für den Ladezustand der Batterie (3) sowie einer Ladezustandsanzeige (13), **dadurch gekennzeichnet, dass** die Überwachungseinrichtung (11) in dem Steuergerät (7) integriert ist.

2. Steuerungseinrichtung nach Anspruch 1, **dadurch gekennzeichnet, dass** die Überwachungseinrichtung (11) die Anzahl der von der Fernbedienung (2) an das Steuergerät (7) gesendeten Signale addiert, die Anzahl der Signale mit einem empirischen Einzelentladungswert zu einem Entladungswert multipliziert, diesen Entladungswert in einem Speichermodul (10) des Steuergerätes (7) speichert und den Entladungswert von einem Voll-Ladezustand der Batterie (3) subtrahiert.

3. Steuerungseinrichtung nach Anspruch 2, **dadurch gekennzeichnet, dass** die Überwachungseinrichtung (11) dem Entladungswert eine betriebszeitabhängige Entladung zuordnet.

4. Steuerungseinrichtung nach Anspruch 2, **dadurch gekennzeichnet, dass** die Überwachungseinrichtung (11) mit einer Rücksetzeinrichtung (16) für den Entladungswert gekoppelt ist, deren Beaufschlagung bei einem Wechsel der Batterie (3) den Kapazitätswert des Voll-Ladezustandes in das Speichermodul (10) einschreibt.

5. Steuerungseinrichtung nach Anspruch 4, **dadurch gekennzeichnet, dass** die Rücksetzeinrichtung (16) zum Einschreiben des Kapazitätswertes des Voll-Ladezustandes über einen Diagnosestecker eines Fahrzeug-Bussystems (12) mit einem Diagnosetestgerät verbunden ist.

6. Steuerungseinrichtung nach Anspruch 4 oder 5, **dadurch gekennzeichnet, dass** die Rücksetzeinrichtung (16) einen manuell beaufschlagbaren Rücksetzschalter (17) umfasst.

7. Steuerungseinrichtung nach einem der Ansprüche 1 bis 4, **dadurch gekennzeichnet, dass** die Überwachungseinrichtung (11) über das Fahrzeug-Bussystem (12) mit der Ladezustandsanzeige (13) gekoppelt ist.

8. Steuerungseinrichtung nach Anspruch 7, **dadurch gebkennzeichnet,** dass die Ladezustandsanzeige (13) in eine Anzeigeeinrichtung (14) eines Bordcomputers im Innenraum des Kraftfahrzeuges integriert ist.

9. Steuerungseinrichtung nach Anspruch 8, **dadurch gekennzeichnet, dass** die Anzeigeeinrichtung (14) die Restkapazität der Batterie (3) symbolisch oder als Klartext zur Darstellung bringt.

10. Steuerungseinrichtung nach einem der Ansprüche 1 bis 9, **dadurch gekennzeichnet, dass** die Ladezustandsanzeige (13) bei Unterschreiten eines vorgegebenen Restkapazitäts-Schwellwertes rechnergesteuert ein Warnsignal darstellt.

11. Steuerungseinrichtung nach einem der Ansprüche 1 bis 10, **dadurch gekennzeichnet, dass** die Fernbedienung (2) als Funkschlüssel (1) und das Steuergerät (7) als Zentralverriegelungssteuergerät (6) ausgebildet ist.
